# EUROPÄISCHE PATENTSCHRIFT

(11) **EP 2 548 222 B1**
(45) Veröffentlichungstag und Bekanntmachung des Hinweises auf die Patenterteilung: **30.01.2019**
(21) Anmeldenummer: 11707165.4
(22) Anmeldetag: 07.03.2011
(51) Int. Cl.: H01L 23/06, H01L 33/56, H01L 33/48

(54) **OPTOELEKTRONISCHES BAUELEMENT UND VERFAHREN ZU DESSEN HERSTELLUNG**
OPTOELECTRONIC COMPONENT AND METHOD FOR PRODUCING SAME
COMPOSANT OPTOÉLECTRONIQUE ET PROCÉDÉ DE SA FABRICATION

(30) Priorität: 15.03.2010 DE 102010011428
(43) Veröffentlichungstag der Anmeldung: 23.01.2013
(73) Patentinhaber: OSRAM Opto Semiconductors GmbH, 93055 Regensburg (DE)
(72) Erfinder: KRÄUTER, Gertrud, 93051 Regensburg (DE)
(74) Vertreter: Epping - Hermann - Fischer
(86) Internationale Anmeldenummer: PCT/EP2011/053385
(87) Internationale Veröffentlichungsnummer: WO 2011/113721

(56) Entgegenhaltungen:
- EP-A2- 0 663 679
- EP-A2- 1 923 897
- WO-A2-2006/114082
- DE-A1-102005 061 828

## Beschreibung

Es wird ein optoelektronisches Bauelement nach dem Anspruch 1 angegeben.

Ein weit verbreitetes Problem von optoelektronischen Bauelementen ist es, deren einzelne Bestandteile an die unterschiedlichen Anforderungen anzupassen.

Eine Aufgabe von Ausführungsformen der Erfindung besteht darin, ein optoelektronisches Bauelement bereitzustellen, welches ein Gehäuse umfasst, das an unterschiedliche Anforderungen angepasst ist.

Die Aufgabe wird durch ein optoelektronisches Bauelement nach dem Anspruch 1 gelöst. Weitere Ausführungsformen des optoelektronischen Bauelements sowie Verfahren zu dessen Herstellung sind Gegenstand weiterer abhängiger Patentansprüche.

Die Erfindung betrifft ein optoelektronisches Bauelement umfassend ein Gehäuse, welches einen ersten Teilbereich mit einem ersten Thermoplasten und einen zweiten Teilbereich mit einem zweiten Thermoplasten umfasst, eine Ausnehmung in dem Gehäuse, ein strahlungsemittierendes Bauteil, welches in der Ausnehmung angeordnet ist, wobei der erste Thermoplast durch Bestrahlung vernetzt wurde.

Dadurch dass das optoelektronische Bauelement ein Gehäuse umfasst, welches mindestens zwei unterschiedliche Teilbereiche umfasst, von denen jeder einen Thermoplasten umfasst, ist es möglich, die physikalischen und chemischen Eigenschaften des ersten Teilbereichs und des zweiten Teilbereichs jeweils auf ihre Anforderungen und Funktionen im Gehäuse abzustimmen.

Durch die Vernetzung des ersten Thermoplasten, der von Natur aus keine Vernetzungen aufweist, erhält dieser eine erhöhte Stabilität. Diese erhöhte Stabilität kann sowohl chemischer wie auch physikalischer Natur sein. Der erste Teilbereich, welcher den ersten Thermoplasten umfasst, weist somit eine höhere Resistenz beispielsweise gegenüber Zerstörung, Verformung oder Verfärbung beispielsweise durch den Einfluss von Hitze, Bestrahlung oder auch mechanischen Einfluss auf.

In einer Ausführungsform der Erfindung unterscheidet sich der erste Thermoplast von dem zweiten Thermoplast.

Dadurch, dass der erste Thermoplast sich von dem zweiten Thermoplast unterscheidet, ist es möglich, den ersten Teilbereich beziehungsweise den zweiten Teilbereich des Gehäuses getrennt voneinander spezifisch auf ihre jeweiligen Anforderungen anzupassen. Hierbei kann beispielsweise der Teilbereich, welcher der Strahlung des strahlungsemittierenden Bauteils ausgesetzt ist, eine besonders hohe Resistenz gegenüber dieser Strahlung oder beispielsweise eine besonders hohe Reflektivität bezüglich dieser Strahlung aufweisen. Hingegen kann der andere Teilbereich beispielsweise eine erhöhte thermische Stabilität aufweisen, was dazu führen kann, dass das optoelektronische Bauelement beispielsweise mittels Lötens auf einem anderen Bauteil befestigt werden kann.

In einer weiteren Ausführungsform der Erfindung weist der erste Thermoplast eine höhere thermische Stabilität auf als der zweite Thermoplast.

Dies erweist sich dann als besonders vorteilhaft, wenn der erste Teilbereich, welcher den ersten Thermoplasten umfasst, hohen thermischen Anforderungen ausgesetzt ist. Der erste Teilbereich kann beispielsweise während des Fertigungsprozesses des optoelektronischen Bauelements einer höheren thermischen Belastung ausgesetzt sein, sowie auch in nachfolgenden Montageschritten, die auf die Fertigungsschritte des optoelektronischen Bauelements folgen. Vorzugsweise umfassen die Teilbereiche des Gehäuses, die erhöhten thermischen Anforderungen ausgesetzt sind, den ersten Thermoplasten.

In einer weiteren Ausführungsform weist der erste Thermoplast nach dem Vernetzen eine Stabilität bis zu einer Temperatur von mindestens 275 °C auf.

Dies bedeutet unter anderem, dass der Thermoplast dieser Temperatur ausgesetzt werden kann, ohne dass es zur Verfärbung oder Verformung dieses Thermoplasten kommt. Dadurch, dass der Thermoplast eine thermische Stabilität bis zu 275 °C aufweist, ist es möglich, an dem ersten Teilbereich, welcher den ersten Thermoplasten umfasst, beispielsweise Lötprozesse durchzuführen, die mit einer Temperatur bis zu 275 °C arbeiten. Vorzugsweise weist der erste Thermoplast nach dem Vernetzen eine Stabilität bis zu einer Temperatur von mindestens 300 °C auf.

In einer weiteren Ausführungsform ist der erste Teilbereich als Gehäusegrundkörper ausgeformt.

Unter Gehäusegrundkörper ist in Zusammenhang mit dieser Erfindung jener Teilbereich des Gehäuses zu verstehen, welcher unter anderem den Boden des Gehäuses darstellt. Des Weiteren kann der Gehäusegrundkörper auch noch einen Rahmen ausformen, welcher eine Ausnehmung aufweist, in der das strahlungsemittierende Bauteil angeordnet ist. Der Gehäusegrundkörper stellt unter anderem jenen Teil des Gehäuses dar, welcher in Verbindung mit einem Leiterrahmen treten kann.

In einer weiteren Ausführungsform der Erfindung weist der erste Thermoplast ein Vernetzungsadditiv auf.

Dieses Vernetzungsadditiv fördert die Vernetzung des Thermoplasten, die durch Bestrahlung zustande kommt. Hierbei kann es sich um ein Vernetzungsadditiv handeln, das beispielsweise die Geschwindigkeit der Vernetzung oder aber auch den Grad der Vernetzung beeinflusst. Es kann sich hierbei aber auch um ein Vernetzungsadditiv handeln, welches in Kombination mit dem entsprechenden Thermoplasten überhaupt erst eine Vernetzung ermöglicht. Das Vernetzungsadditiv ist hierbei auf den ersten Thermoplasten abgestimmt, sodass durch die vorgegebene Bestrahlung das gewünschte Maß an Vernetzung erreicht wird, und somit in dem Thermoplasten die gewünschten physikalischen und chemischen Eigenschaften erzielt werden. In einer weiteren Ausführungsform der Erfindung ist das Vernetzungsadditiv ausgewählt aus: Triallylisocyanat, Trimethylolpropantriacrylat, Pentaerythrioltriacrylat.

Jene Vernetzungsadditive haben sich in Versuchen als besonders vorteilhaft herausgestellt.

In einer weiteren Ausführungsform der Erfindung ist der zweite Teilbereich auf dem ersten Teilbereich angeordnet.

Hierbei sind Ausführungsbeispiele denkbar, in denen der zweite Teilbereich direkt auf dem ersten Teilbereich angeordnet ist, wie auch Ausführungsbeispiele, bei denen zwischen dem zweiten Teilbereich und dem ersten Teilbereich ein weiterer dritter Teilbereich angeordnet ist. In jedem Fall liegt jedoch eine klare Trennung zwischen dem ersten Teilbereich und dem zweiten Teilbereich vor. Somit kann kein Teilbereich gleichzeitig dem ersten Teilbereich wie auch dem zweiten Teilbereich angehören.

In einer weiteren Ausführungsform der Erfindung ist der erste Teilbereich aus dem ersten Thermoplasten ausgeformt.

In einer weiteren Ausführungsform der Erfindung ist der zweite Teilbereich aus dem zweiten Thermoplasten ausgeformt.

Dadurch, dass der erste beziehungsweise der zweite Teilbereich aus dem ersten beziehungsweise zweiten Thermoplasten ausgeformt ist, bestimmen die jeweiligen Thermoplasten maßgeblich die physikalischen und chemischen Eigenschaften der jeweiligen Teilbereiche.

In einer weiteren Ausführungsform der Erfindung ist der zweite Teilbereich als Reflektor ausgeformt.

Bei dieser Ausführungsform weist der zweite Thermoplast vorzugsweise eine erhöhte Resistenz gegenüber der Strahlung auf, welche von dem strahlungsemittierenden Bauteil emittiert wird, welches in dem Reflektor angeordnet ist. Die Resistenz des zweiten Thermoplasten ist hierbei auf die Wellenlänge der emittierten Strahlung abgestimmt. Wird somit beispielsweise von dem strahlungsemittierenden Bauteil eine Strahlung emittiert, welche auch einen UV-Bestandteil aufweist, so ist der zweite Thermoplast und dessen Vernetzungsgrad so ausgewählt, dass der zweite Thermoplast beziehungsweise der Reflektor, welcher diesen zweiten Thermoplasten umfasst, eine erhöhte Resistenz und somit verbesserte Stabilität gegenüber UV-Strahlung aufweist. Durch die erhöhte Stabilität gegenüber der emittierten Strahlung werden eine Zerstörung und Alterungserscheinungen des Reflektors vermindert. Hierdurch wird die Lebensdauer des optoelektronischen Bauelements erhöht.

Gemäss der Erfindung weist der zweite Thermoplast eine höhere Reflektivität gegenüber der Strahlung auf, die von dem strahlungsemittierenden Bauteil emittiert wird, als der erste Thermoplast.

Dadurch, dass der zweite Thermoplast eine höhere Reflektivität aufweist, kann aus jenem beispielsweise der Teilbereich des Gehäuses ausgeformt werden, welcher den Reflektor ausbildet. Dadurch, dass das Gehäuse unterschiedliche Teilbereiche aufweist, welche ihrerseits wiederum unterschiedliche Thermoplasten umfassen, ist es möglich, die entsprechenden Teilbereiche direkt an ihrer Anforderung anzupassen. Hierdurch kann beispielsweise auf eine nachträgliche Beschichtung der Innenwand des Reflektors verzichtet werden, da bereits der erste Thermoplast so ausgewählt wurde, dass er die gewünschte Reflektivität aufweist. Auf der anderen Seite ist es durch die Unterteilung in unterschiedliche Teilbereiche somit nicht notwendig, das gesamte Gehäuse aus einem Material zu fertigen, welches diese hohe Reflektivität aufweist. Die hohe Reflektivität muss nicht dem Thermoplasten selbst zwingend zu Eigen sein, sondern kann auch durch Zusatzstoffe, welche den Thermoplasten zugesetzt werden, erzielt werden. Bei dem Zusatzstoff kann es sich beispielsweise um einen Farbpigment oder ein Metall handeln. Bei dem Farbpigment handelt es sich vorzugsweise um einen weißen Farbpigment. Ein anderer Teilbereich des Gehäuses kann dementsprechend je nach seinen Anforderungen andere Zusätze aufweisen. Durch eine erhöhte Reflektivität kann die Lichtausbeute des optoelektronischen Bauelements erhöht werden.

Gemäss der Erfindung ist der erste Thermoplast ausgewählt aus: Polyetherimid, Polysulfon, Polyphenylsulfid, LCPs, PEEK.

In einer weiteren Ausführungsform der Erfindung ist der zweite Thermoplast ausgewählt aus: Polyamid, Polybutylenterephthalat, Polyethylenterephthalat, Polyester, Polyester-Copolymere, fluorierte Polymere.

In Versuchen haben sich diese Polymere als vorteilhaft herausgestellt. Als besonders vorteilhaft haben sich Polybutylenterephthalat und Polyamid erwiesen. Hierbei können Polyamid, Polybutylenterephthalat und Polyester-Copolymere durch beispielsweise beta-Strahlung vernetzt werden.

In einer weiteren Ausführungsform der Erfindung ist der zweite Thermoplast strahlenvernetzt.

Somit weist nicht nur der erste Thermoplast, sondern auch der zweite Thermoplast eine erhöhte Stabilität und Resistenz durch die Vernetzung mittels Bestrahlung auf. Somit kann beispielsweise der eine Thermoplast und dessen Vernetzungsgrad so gewählt werden, dass dieser eine besonders hohe Resistenz gegenüber thermischen Einflüssen hat, und der andere Thermoplast und dessen Vernetzungsgrad, dass dieser eine besonders gute Resistenz gegenüber Bestrahlung aufweist. Somit weist das Gehäuse zumindest zwei Teilbereiche auf, welche jeweils Thermoplasten umfassen beziehungsweise aus Thermoplasten ausgeformt wurden, und gegenüber nichtvernetzten Thermoplasten eine gesteigerte Resistenz aufweisen, welche jeweils an die Anforderungen des jeweiligen Teilbereichs des Gehäuses abgestimmt sind.

In einer weiteren Ausführungsform der Erfindung ist der erste Teilbereich frei von dem zweiten Thermoplasten und der zweite Teilbereich frei von dem ersten Thermoplasten.

Dies bedeutet, dass in dieser Ausführungsform der erste Teilbereich nicht den zweiten Thermoplasten umfasst und der zweite Teilbereich nicht den ersten Thermoplasten umfasst. Die Thermoplasten des ersten Teilbereichs und des zweiten Teilbereichs sind in dieser Ausführungsform speziell auf die Anforderungen des jeweiligen Teilbereichs abgestimmt und es liegt nicht ein Gemisch aus zwei Thermoplasten vor, aus dem sowohl der erste Teilbereich wie auch der zweite Teilbereich ausgeformt wird.

In einer Ausführungsform der Erfindung handelt es sich bei dem strahlungsemittierenden Bauteil um eine LED.

Es sind auch Ausführungsformen denkbar, bei denen in einem Gehäuse mehrere LEDs angeordnet sind. Diese LEDs können sowohl die gleiche wie auch unterschiedliche Wellenlängenbereiche emittieren. Weist das Gehäuse mehrere Ausnehmungen auf oder eine große Ausnehmung, welche durch Einziehen von Trennwänden mehrere Unterbereiche aufweist, welche beispielsweise unterschiedliche Reflektoren ausformen, so kann hier jeder Reflektor einen eigenen Teilbereich darstellen, der jeweils einen spezifischen Thermoplasten aufweist. Dieser kann in Stabilität und Reflektivität speziell auf die LED abgestimmt sein, die in jenem Reflektor beziehungsweise Unterbereich angeordnet ist. Über die Auswahl des entsprechenden Thermoplasten und dessen Vernetzungsgrad kann unter anderem die Reflektivität der unterschiedlichen Reflektoren, welche jeweils um die einzelnen LEDs angeordnet sind, beeinflusst werden. Über die Reflektivität kann somit auch die Lichtausbeute der einzelnen LEDs und somit auch deren Anteil am Mischlicht, welches letztendlich vom optoelektronischen Bauelement emittiert wird, beeinflusst werden. Über den unterschiedlichen Anteil der einzelnen LEDs am Mischlicht kann der Gesamteindruck des emittierten Lichtes des optoelektronischen Bauteils gesteuert werden.

Neben dem optoelektronischen Bauelement selbst wird auch ein Verfahren zur Herstellung eines optoelektronischen Bauelements, wie es zuvor beschrieben wurde, beansprucht.

Ein Verfahren zur Herstellung eines optoelektronischen Bauelements, wie es zuvor beschrieben wurde, umfasst hierbei die Verfahrensschritte: Ausformen des ersten Teilbereiches des Gehäuses aus einem Material, welches den ersten Thermoplasten umfasst als Verfahrensschritt A), Ausformen des zweiten Teilbereiches des Gehäuses aus einem Material, welches den zweiten Thermoplasten umfasst als Verfahrensschritt B), Bestrahlen des ersten Teilbereiches, so dass der erste Thermoplast vernetzt wird als Verfahrenschritt C) und Einbringen des strahlungsemittierenden Bauteils in die Ausnehmung des Gehäuses als Verfahrensschritt D).

Hierbei kann das Bestrahlen des ersten Teilbereichs, der Verfahrensschritte C), welcher zur Vernetzung des ersten Thermoplasten führt, sowohl vor wie auch nach dem Verfahrensschritt B) erfolgen.

Für den Fall, dass auch der zweite Teilbereich einen Thermoplasten umfasst, welcher mittels Bestrahlung vernetzt wird, können der erste Teilbereich und der zweite Teilbereich in einem einzigen Bestrahlungsschritt bestrahlt werden. Ebenso ist es aber auch denkbar, dass jeder Teilbereich für sich mit einer speziellen Bestrahlungsdosis bestrahlt wird. Hierbei kann die Strahlungsdosis auf den jeweiligen Thermoplasten beziehungsweise auf den angestrebten Vernetzungsgrad des Thermoplasten abgestimmt sein.

Vorzugsweise wird der Teilbereich zuerst ausgeformt, welcher eine geringere thermische Stabilität aufweist. Hierdurch kann beim Ausformen des thermisch stabileren Teilbereichs, die Kontaktfläche zu dem Teilbereich mit der geringeren thermischen Stabilität kurzzeitig erwärmt werden, wodurch zwischen den beiden Teilbereichen ein fester Verbund ausgebildet werden kann.

In einer weiteren Variante des Verfahrens wird der erste Teilbereich im Verfahrensschritt C) mit einer Bestrahlungsdosis von 33 bis 165 kGy bestrahlt.

Die Strahlungsdosis kann hierbei auf den Thermoplasten wie auch auf die Konzentration des Vernetzungsadditives, die im Thermoplasten vorliegt, abgestimmt werden. Des Weiteren kann die Strahlungsdosis auch auf dem gewünschten Vernetzungsgrad, welcher in den Thermoplast erzielt werden soll, abgestimmt sein. Die Bestrahlung kann beispielsweise mit Beta-Strahlung erfolgen.

In einer weiteren Variante des Verfahrens erfolgt das Ausformen im Verfahrensschritt A) mittels Spritzguss.

In einer weiteren Variante des Verfahrens erfolgt das Ausformen im Verfahrensschritt B) mittels Spritzguss.

Somit kann bei dem Verfahren zur Herstellung des optoelektronischen Bauelements ein Zwei-Komponenten-Spritzgussverfahren zur Anwendung kommen.

Im Folgenden sollen Varianten der Erfindung anhand von Figuren und Ausführungsbeispielen näher erläutert werden.
- Figur 1: zeigt einen schematischen Querschnitt einer ersten Ausführungsform eines erfindungsgemäßen optoelektronischen Bauelements,
- Figur 2: zeigt im schematischen Querschnitt eine zweite Ausführungsform eines erfindungsgemäßen optoelektronischen Bauelements.

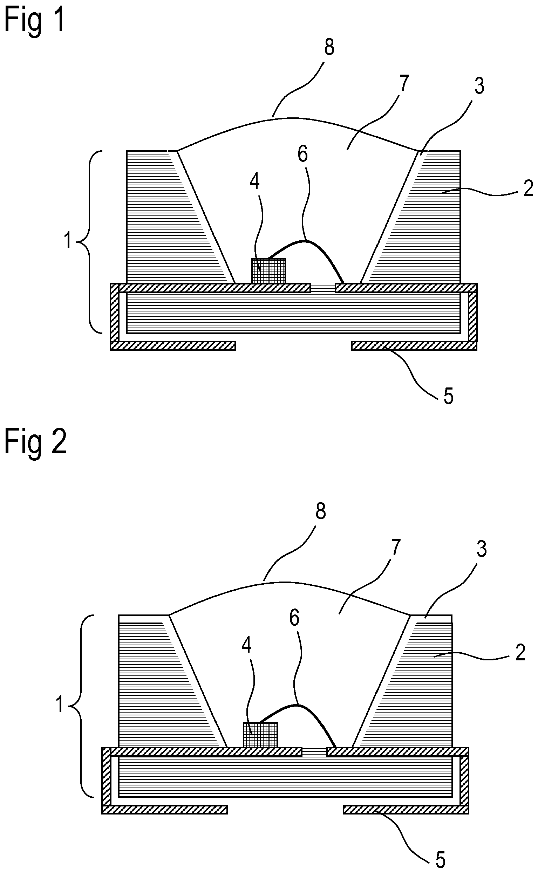

In Figur 1 zeigt ein optoelektronisches Bauelement, welches ein Gehäuse 1 aufweist, welches einen ersten Teilbereich 2 und einen zweiten Teilbereich 3 umfasst. In diesem Ausführungsbeispiel ist der erste Teilbereich 2 als Gehäusegrundkörper ausgeformt, und der zweite Teilbereich 3 als Reflektor. Im Inneren des Reflektors ist ein strahlungsemittierendes Bauteil 4 angeordnet, bei dem es sich in diesem Ausführungsbeispiel um eine LED handelt. Das strahlungsemittierende Bauteil 4 ist elektrisch leitend mit dem ersten wie auch über den Bonddraht 6 mit dem zweiten Teil des Leiterrahmens 5 verbunden. Die Ausnehmung des Gehäuses 1 in der das strahlungsemittierende Bauteil 4 angeordnet ist, ist mit einem Verguss 7 ausgegossen, welcher an der Strahlungsaustrittsfläche als Linse 8 ausgeformt ist.

Bei dem in Figur 1 dargestellten Ausführungsbeispiel weist der erste Teilbereich 2 eine besonders gute thermische Stabilität auf, wohingegen der zweite Teilbereich 3 eine besonders gute Stabilität gegenüber Strahlung aufweist. Somit wird der erste Teilbereich 2 durch den zweiten Teilbereich 3 von der Strahlung geschützt, welche von dem strahlungsemittierenden Bauteil 4 abgegeben wird. Andererseits kann der zweite Teilbereich 3 durch den ersten Teilbereich 2 von zu hohen Temperaturen geschützt werden, welche beispielsweise durch Lötprozesse auf die Unterseite des optoelektronischen Bauelements einwirken. Somit ist jeder der beiden Teilbereiche des Gehäuses 1 aufgrund der von ihm umfassten Thermoplasten jeweils auf die entsprechenden Anforderungen angepasst.

In Zusammenhang mit dieser Erfindung ist der Verguss 7, welcher sich in der Ausnehmung des Gehäuses 1 befindet, nicht als Bestandteil des Gehäuses anzusehen, sondern lediglich als Bestandteil des optoelektronischen Bauelements insgesamt. Die Figur 2 zeigt ein weiteres Ausführungsbeispiel, welches weitgehend dem Ausführungsbeispiel entspricht, wie es in Figur 1 dargestellt ist. Das Ausführungsbeispiel, welches in Figur 2 dargestellt ist, umfasst zusätzlich auf der Oberseite des Gehäusegrundkörpers auch noch einen Teil des zweiten Teilbereichs 3. Hierdurch ist in der Gehäusegrundkörper, welcher durch den ersten Teilbereich 2 ausgebildet wird, nicht nur von der Strahlung geschützt, welche durch das strahlungsemittierende Bauteil 4 emittiert wird, sondern zusätzlich auch noch von jener Strahlung, welche von oben auf das optoelektronische Bauelement einwirkt.

## Patentansprüche

1. Optoelektronisches Bauelement mit einem,
- Gehäuse (1), welches einen ersten Teilbereich (2) mit einem ersten Thermoplasten und einen zweiten Teilbereich (3) mit einem zweiten Thermoplasten umfasst,
- eine Ausnehmung in dem Gehäuse (1),
- ein strahlungsemittierendes Bauteil (4), welches in der Ausnehmung angeordnet ist und eine Strahlung emittieren kann, **dadurch gekennzeichnet, dass**
- der erste Teilbereich (2) durch den zweiten Teilbereich (3) von der Strahlung geschützt wird,
- der zweite Thermoplast eine höhere Reflektivität gegenüber der Strahlung aufweist als der erste Thermoplast, und
- der erste Thermoplast ausgewählt ist aus: Polyetherimid, Polysulfon, Polyphenylsulfid, LCPs und PEEK, wobei der erste Thermoplast durch Bestrahlung vernetzt wurde.

2. Optoelektronisches Bauelement nach Anspruch 1,
wobei der erste Thermoplast unterschiedlich zu dem zweiten Thermoplasten ist.

3. Optoelektronisches Bauelement nach einem der vorhergehenden Ansprüche,
wobei der erste Thermoplast eine höhere thermische Stabilität aufweist als der zweite Thermoplast.

4. Optoelektronisches Bauelement nach einem der vorhergehenden Ansprüche,
wobei der erste Thermoplast nach dem Vernetzen eine thermische Stabilität bis zu einer Temperatur von mindestens 275 °C aufweist.

5. Optoelektronisches Bauelement nach einem der vorhergehenden Ansprüche,
wobei der erste Teilbereich (2) als Gehäusegrundkörper ausgeformt ist.

6. Optoelektronisches Bauelement nach einem der vorhergehenden Ansprüche,
wobei der erste Thermoplast ein Vernetzungsadditiv aufweist.

7. Optoelektronisches Bauelement nach Anspruch 6,
wobei das Vernetzungsadditiv ausgewählt ist aus:
Triallylisocyanat, Trimethylolpropantriacrylat, Pentaerythrioltriacrylat.

8. Optoelektronisches Bauelement nach einem der vorhergehenden Ansprüche,
wobei der zweite Teilbereich (3) auf dem ersten Teilbereich (2) angeordnet ist.

9. Optoelektronisches Bauelement nach einem der vorhergehenden Ansprüche,
wobei der zweite Teilbereich (3) als Reflektor ausgeformt ist.

10. Optoelektronisches Bauelement nach einem der vorhergehenden Ansprüche,
wobei der zweite Thermoplast ausgewählt ist aus: Polyamid, Polybutylenterephthalat, Polyethylenterephthalat, Polyester, Polyester-Copolymere, fluorierte Polymere.

11. Verfahren mit dem ein optoelektronisches Bauelement nach Anspruch 1 hergestellt wird,
umfassend die Verfahrensschritte:
A) Ausformen des ersten Teilbereiches (2) des Gehäuses (1) aus einem Material, das den ersten Thermoplasten umfasst,
B) Ausformen des zweiten Teilbereiches (3) des Gehäuses (1) aus einem Material, welches den zweiten Thermoplasten umfasst,
C) Bestrahlen des ersten Teilbereiches (2), so dass der erste Thermoplast vernetzt wird,
D) Einbringen des strahlungsemittierenden Bauteils (4) in eine Ausnehmung des Gehäuses (1).

12. Verfahren nach Anspruch 11,
wobei der erste Teilbereich (2) im Verfahrensschritt C) mit einer Bestrahlungsdosis von 33 bis 165 kGy bestrahlt wird.

13. Verfahren nach einem der Ansprüche 11 oder 12,
wobei das Ausformen im Verfahrensschritt A) mittels Spritzguss erfolgt.

## Claims

1. An optoelectronic device with a,
- housing (1) which comprises a first partial region (2) with a first thermoplast and a second partial region (3) with a second thermoplast,
- a recess in the housing (1),
- a radiation-emitting component (4), which is arranged in the recess and can emit radiation, **characterized in that**
- the first partial region (2) is protected from the radiation by the second partial region (3),
- the second thermoplast has a higher reflectivity to the radiation than the first thermoplast, and
- the first thermoplast is selected from: polyetherimide, polysulfone, polyphenylsulfide, LCPs and PEEK, wherein the first thermoplast has been crosslinked by irradiation.

2. The optoelectronic device according to claim 1,
wherein the first thermoplast is different from the second thermoplast.

3. The optoelectronic device according to one of the preceding claims,
wherein the first thermoplast has a higher thermal stability than the second thermoplast.

4. The optoelectronic device according to one of the preceding claims,
wherein the first thermoplast has a thermal stability up to a temperature of at least 275°C after crosslinking.

5. The optoelectronic device according to one of the preceding claims,
wherein the first partial region (2) is formed as a housing base body.

6. The optoelectronic device according to one of the preceding claims,
wherein the first thermoplast comprises a crosslinking additive.

7. The optoelectronic device according to claim 6,
wherein the crosslinking additive is selected from: triallyl isocyanate, trimethylolpropane triacrylate, pentaerythriol triacrylate.

8. The optoelectronic device according to one of the preceding claims,
wherein the second partial region (3) is arranged on the first partial region (2).

9. The optoelectronic device according to one of the preceding claims,
wherein the second partial region (3) is formed as a reflector.

10. The optoelectronic device according to one of the preceding claims,
wherein the second thermoplast is selected from: Polyamide, polybutylene terephthalate, polyethylene terephthalate, polyester, polyester copolymers, fluorinated polymers.

11. A method of manufacturing an optoelectronic device according to claim 1,
comprising the process steps:
A) moulding the first partial region (2) of the housing (1) from a material comprising the first thermoplast,
B) moulding the second partial region (3) of the housing (1) from a material comprising the second thermoplast,
C) irradiating the first partial region (2) so that the first thermoplast is cross-linked,
D) introducing the radiation-emitting component (4) into a recess in the housing (1).

12. The method according to claim 11,
wherein the first partial region (2) is irradiated in process step C) with an irradiation dose of 33 to 165 kGy.

13. The method according to one of claims 11 or 12,
wherein the moulding takes place in process step A) by means of injection moulding.

## Revendications

1. Composant optoélectronique comportant
- un boîtier (1) comprenant une première zone partielle (2) avec un premier thermoplastique et une deuxième zone partielle (3) avec un deuxième thermoplastique,
- un évidement dans le boîtier (1),
- un composant émetteur de rayonnement (4), placé dans l'évidement et pouvant émettre un rayonnement,
**caractérisé en ce que**
- la première zone partielle (2) est protégée du rayonnement par la deuxième zone partielle (3),
- le second thermoplastique présente une réflectivité au rayonnement supérieure à celle du premier thermoplastique et
- le premier thermoplastique est choisi parmi :
polyétherimide, polysulfone, polyphénylsulfure, des PCL et PEEK, le premier thermoplastique ayant été réticulé par irradiation.

2. Composant optoélectronique selon la revendication 1,
dans lequel le premier thermoplastique est différent du second thermoplastique.

3. Composant optoélectronique selon l'une des revendications précédentes,
dans lequel le premier thermoplastique présente une stabilité thermique supérieure à celle du second thermoplastique.

4. Composant optoélectronique selon l'une des revendications précédentes,
dans lequel le premier thermoplastique présente une stabilité thermique jusqu'à une température d'au moins 275°C après réticulation.

5. Composant optoélectronique selon l'une des revendications précédentes,
la première zone partielle (2) étant moulée en tant que corps de base du boîtier.

6. Composant optoélectronique selon l'une des revendications précédentes,
dans lequel le premier thermoplastique comprend un additif de réticulation.

7. Composant optoélectronique selon la revendication 6,
dans lequel l'additif de réticulation est choisi parmi :
isocyanurate de triallyle, triacrylate de triméthylolpropane, triacrylate de pentaérythriol.

8. Composant optoélectronique selon l'une des revendications précédentes,
dans lequel la deuxième zone partielle (3) est disposée sur la première zone partielle (2).

9. Composant optoélectronique selon l'une des revendications précédentes,
dans lequel la deuxième région partielle (3) est moulée en tant que réflecteur.

10. Composant optoélectronique selon l'une des revendications précédentes,
dans lequel le second thermoplastique est choisi parmi :
polyamide, polybutylène téréphtalate, polyéthylène téréphtalate, polyester, copolymères de polyester, polymères fluorés.

11. Procédé de fabrication d'un composant optoélectronique selon la revendication 1,
comprenant les étapes suivantes :
A) moulage de la première zone partielle (2) du boîtier (1) à partir d'un matériau comprenant le premier thermoplastique,
B) moulage de la deuxième zone partielle (3) du boîtier (1) à partir d'un matériau comprenant le deuxième thermoplastique,
C) irradiation de la première zone partielle (2) de sorte que le premier thermoplastique soit réticulé,
D) introduction du composant émetteur de rayonnement (4) dans un évidement du boîtier (1).

12. Procédé selon la revendication 11,
dans lequel la première zone partielle (2) est irradiée à l'étape C) à une dose d'irradiation comprise entre 33 et 165 kGy.

13. Procédé selon l'une des revendications 11 ou 12,
lors duquel le moulage a lieu par moulage par injection à l'étape A).
